# EUROPEAN PATENT SPECIFICATION

(11) **EP 1 562 411 B1**
(45) Date of publication and mention of the grant of the patent: **06.06.2012**
(21) Application number: 05001964.5
(22) Date of filing: 31.01.2005
(51) Int. Cl.: H05K 3/24, C23C 18/16

(54) **Metal/ceramic bonding member and method for producing same**
Metall/Keramisches Verbundelement und Verfahren zu dessen Herstellung
Membre composite métal/céramique et son procédé de fabrication

(30) Priority: 06.02.2004 JP 2004030139
(43) Date of publication of application: 10.08.2005
(73) Proprietor: DOWA METALTECH CO., LTD., Chiyoda-ku Tokyo 101-0021 (JP)
(72) Inventor: Tsukaguchi, Nobuyoshi, Shiojiri-shi Nagano 399-0703 (JP); Iyoda, Ken, Shiojiri-shi Nagano 399-0703 (JP)
(74) Representative: Manitz, Finsterwald & Partner GbR

(56) References cited:
- US-A- 4 848 646
- PATENT ABSTRACTS OF JAPAN vol. 2003, no. 05, 12 May 2003 (2003-05-12) & JP 2003 031720 A (DOWA MINING CO LTD), 31 January 2003 (2003-01-31)
- PATENT ABSTRACTS OF JAPAN vol. 2003, no. 05, 12 May 2003 (2003-05-12) & JP 2003 013246 A (FUJI ELECTRIC CO LTD), 15 January 2003 (2003-01-15)
- PATENT ABSTRACTS OF JAPAN vol. 1995, no. 05, 30 June 1995 (1995-06-30) & JP 07 038232 A (ASAHI CHEM IND CO LTD), 7 February 1995 (1995-02-07)
- PATENT ABSTRACTS OF JAPAN vol. 016, no. 076 (C-0914), 25 February 1992 (1992-02-25) & JP 03 267377 A (SEIKO INSTR INC), 28 November 1991 (1991-11-28)
- PATENT ABSTRACTS OF JAPAN vol. 1995, no. 11, 26 December 1995 (1995-12-26) & JP 07 224387 A (NKK CORP), 22 August 1995 (1995-08-22)

## Description

### BACKGROUND OF THE INVENTION

### Field of the Invention

The present invention generally relates to a metal/ceramic bonding member wherein a metal member is bonded to a ceramic member, and a method for producing the same. More specifically, the invention relates to a metal/ceramic circuit board for mounting thereon a large-power element, such as a metal/ceramic circuit board for a power module, and a method for producing the same.

### Description of the Prior Art

As conventional methods for plating a predetermined portion of the surface of a metal circuit plate of a metal/ceramic circuit board, there are known a method (a zinc immersion process) wherein, after an organic solvent-soluble resist is applied to the surface of the metal circuit plate to carry out an activating process with an alkaline zinc-immersion plating solution (an activating process based on deposition of zinc, the activating process being capable of carrying out a strong chemical polishing), an electroless nickel plating is carried out, and thereafter, the resist is removed with an organic solvent, and a method (a palladium activating process) wherein, after an alkali peeling type resist is applied to the surface of the metal circuit plate to carry out a palladium activating process, an electroless nickel plating is carried out, and thereafter, the resist is removed with an alkali (see, e.g., Japanese Patent Laid-Open No. 2003-31720).

Conventional zinc immersion processes use an organic solvent-soluble resist as described in Japanese Patent Laid-Open No. 2003-31720, since a zinc immersion solution is a strong alkaline solution based on NaOH to dissolve an alkali peeling type resist. However, if an organic solvent-soluble resist is used, it is required to use a large amount of organic solvent to increase costs for equipments, chemicals and environmental pollution control measures.

If an alkali peeling type resist is used in a zinc immersion process and if an acidic zinc immersion solution, such as a hydrochloric acid solution of zinc chloride, is used as a zinc immersion solution, it is possible to solve the aforementioned problems caused when an organic solvent-soluble resist is used, and it is possible to prevent the resist frombeing dissolved. However, if such an acidic zinc immersion solution is used, there are some cases where deposition of zinc is easily uneven to cause uneven plating, and/or chemical polishing is insufficient to deteriorate the appearance of plating, and/or non-plating portions are caused in the vicinity of a resist.

In the palladium activating process disclosed in Japanese Patent Laid-OpenNo. 2003-31720, it is required to carry out a heat treatment after plating in order to improve the adhesion of plating to a base material.

### SUMMARY OF THE INVENTION

It is therefore an object of the present invention to eliminate the aforementioned problems and to provide a method for producing a metal/ceramic bonding member, which is capable of improving the adhesion of plating and productivity without using any organic solvent-soluble resists and without carrying out any heat treatments.

In order to accomplish the aforementioned and other objects, the inventors have diligently studied and found that it is possible to prevent deposition of zinc from being easily uneven to cause uneven plating, it is possible to prevent chemical polishing from being insufficient to deteriorate the appearance of plating, and it is possible to prevent non-plating portions (portions in which plating is not carried out) from being caused in the vicinity of a resist, so that it is possible to improve the adhesion of plating and productivity without using any organic solvent-soluble resists and without carrying out any heat treatments, if an acidic zinc immersion solution containing a fluoride or silicofluoride is used when an activating process based on a zinc immersion process is carried out using an alkali peeling type resist. Thus, the inventors have made the present invention.

According one aspect of the present invention, there is provided a method for producing a metal/ceramic bonding member, the method comprising the steps of: bonding a metal member to a ceramic member; applying an alkali peeling type resist having a predetermined shape on a surface of the metal member bonded to the ceramic member; activating a portion of the surface of the metal member, on which the resist is not applied, with a zinc immersion solution for depositing zinc thereon; and carrying out an electroless nickel alloy plating on the activated portion of the surface of the metal member, and thereafter, removing the resist with an alkali, wherein the zinc immersion solution is acidic and contains a fluoride or silicofluoride.

In the method for producing a metal/ceramic bonding member, the metal member may be made of aluminum or an aluminum alloy. The aluminum alloy may be selected from the group consisting of aluminum-silicon alloys, aluminum-magnesium alloys, aluminum-silicon-boron alloys and aluminum-magnesium-silicon alloys. The activating step may be sequentially carried out twice. In this case, an aqueous acidic solution of an acid selected from the group consisting of nitric acid, hydrochloric acid, sulfuric acid and acetic acid may be used as a zinc deposition film removing solution at the activating step for removing a zinc deposition film with the zinc deposition film removing solution.

The ceramic member may mainly contain a component selected from alumina, aluminum nitride, silicon carbide and silicon nitride. The metal member may be bonded to the ceramic member by a molten metal bonding method, an impregnation bonding method, a brazing bonding method or a direct bonding method. The electroless nickel alloy plating may be selected from the group consisting of a nickel-phosphorus alloy plating, a nickel-boron alloy plating, and a composite plating of a nickel-phosphorus alloy plating and nickel-boron alloy plating. The ceramic member may be a ceramic substrate, and the metal member may be a metal circuit plate having a predetermined circuit pattern. The method for producing a metal/ceramic bonding member may further comprise a step of carrying out at least one of a degreasing process or a chemical polishing process before the activating step.

In a method for producing a metal/ceramic bonding member according to the present invention, an acidic zinc immersion solution containing a fluoride or silicofluoride is used when an activating process based on a zinc immersion process is carried out using an alkali peeling type resist. Therefore, it is possible to prevent deposition of zinc from being easily uneven to cause uneven plating, and it is possible to prevent chemical polishing from being insufficient to deteriorate the appearance of plating. Moreover, it is possible to prevent non-plating portions from being caused in the vicinity of a resist. Thus, it is possible to improve the adhesion of plating and productivity without using any organic solvent-soluble resists and without carrying out any heat treatments.

Furthermore, throughout the specification, the term "zinc immersion process" means a method for immersing a metal, such as aluminum or an aluminum alloy, into a zinc ion containing solution to chemically deposit zinc on the surface of the metal, and the term "zinc immersion solution" means a zinc ion containing solution used for immersing therein a metal, such as aluminum or an aluminum alloy, to chemically deposit zinc on the surface of the metal.

### BRIEF DESCRIPTION OF THE DRAWINGS

The present invention will be understood more fully from the detailed description given herebelow and from the accompanying drawings of the preferred embodiments of the invention. However, the drawings are not intended to imply limitation of the invention to a specific embodiment, but are for explanation and understanding only.

In the drawings:

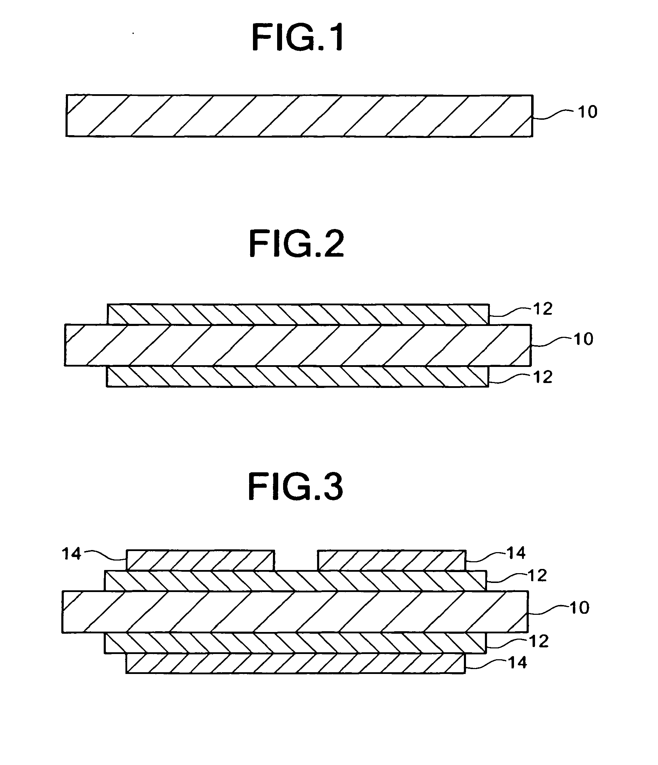

FIGS. 1 through 8 are sectional views showing steps of a method for producing a metal/ceramic bonding member according to the present invention.

### DESCRIPTION OF THE PREFERRED EMBODIMENTS

In a preferred embodiment of a method for producing a metal/ceramic bonding member according to according to the present invention, a metal member bonded to a ceramic member is etched so as to have a desired circuit pattern, or a metal member formed by press working or the like so as to have a desired circuit pattern is bonded to a ceramic substrate, to form a metal circuit plate having a desired circuit pattern. Thereafter, an alkali peeling type resist is applied on a portion other than a plating required portion, such as a chip mounting portion, on the surface of the metal circuit plate by the screen printing, exposure method or the like. Then, the plating required portion on the surface of the metal circuit plate, on which the resist is not applied, is activated with an acidic zinc immersion solution containing a fluoride or silicofluoride. Then, an electroless nickel alloy plating is carried out, and thereafter, the resist is removed with an alkali. Thus, a plating layer having a desired shape is formed on the metal circuit plate.

In general, the metal member may be made of aluminum or an aluminum alloy and may have a thickness of about 0.1 to 0.5 mm. The aluminum alloy may be an aluminum-silicon alloy (Al-Si), an aluminum-magnesium alloy (Al-Mg), an aluminum-silicon-boron alloy (Al-Si-B), or an aluminum-magnesium-silicon alloy (Al-Mg-Si). On the portion of the metal circuit plate which is not plated, aluminum wire bonding can be easily carried out.

In general, the ceramic member may be a ceramic substrate which mainly contains alumina (Al₂O₃), aluminumnitride (AlN), siliconcarbide (SiC) or silicon nitride (Si₃N₄) and which has a thickness of about 0.2 to 1.0 mm.

The method for bonding the metal member to the ceramic member may be any one of the molten metal bonding method, the impregnation bonding method, the brazing bonding method and the direct bonding method.

The electroless nickel alloy plating carried out on the surface of the metal circuit plate may be any one of a nickel-phosphorus alloy plating (Ni-P), a nickel-boron alloy plating (Ni-B), and a composite plating of nickel-phosphorus alloy plating and nickel-boronalloyplating (Ni-P/Ni-B). The thickness of plating is preferably in the range of from 1 µm to 7 µm, and more preferably in the range of from 2 µm to 6 µm. If the thickness of plating is less than 1 µm, the solder wettabilityof plating is deteriorated, and the weather-resistant thereof is also deteriorated. On the other hand, if the thickness of plating exceeds 7 µm, the stress of plating increases. The evaluation of the adhesion of plating can be carried out by the cross-cut method or wire bonding method.

The activating process (the zinc immersion process) with the acidic zinc immersion solution containing a fluoride or silicofluoride is preferably carried out at a temperature of 5 to 30 °C in the pH range of 1 to 5.5. If the temperature is lower than the above temperature range, the substitution reaction is insufficient, and if the temperature is higher than the above temperature range, corrosion excessively proceeds on the surface of the metal circuit plate (an aluminum plate or an aluminum alloy plate). If the pH is lower than the above pH range, dissolution of aluminum excessively proceeds, and if the pH is higher than the above pH range, uneven deposition of zinc easily occurs. The control of pH is preferably carried out by using hydrofluoric acid or hydrofluosilic acid.

The concentration of fluoride or silicofluoride is preferably in the range of from 1 wt% to 10 wt% although it can be suitably changed in accordance with the composition of aluminum or aluminum alloy. If the concentration is lower than the above range, it is difficult to form an activated surface on the surface of aluminum or aluminum alloy. On the other hand, if the concentration is higher than the above range, corrosion excessively proceeds on the surface of aluminum or aluminum alloy, and there is the possibility that ceramic corrodes to deteriorate the strength thereof.

Salts of zinc in the zinc immersion solution are preferably selected from the group consisting of sulfates, chlorides or acetates which do not form insoluble salts with aluminum, although they should not be particularly limited.

Since the zinc deposition film on the surface has a tendency to be rough and uneven if the zinc immersion process is only carried out once, a double zincate process (a process for carrying out the zinc immersion process twice) for carrying out a zinc immersion process and thereafter dissolving and removing a zinc deposition film with chemicals to form a zinc deposition film again is preferably carried out. When the double zincate process is carried out, any one of dilute nitric acid, dilute sulfuric acid, dilute hydrochloric acid and dilute acetic acid is preferably used as a zinc deposition film removing solution in order to dissolve and remove the zinc deposition film, because the zinc deposition film can be uniformly formed. In order to remove the zinc deposition film, the acids are preferably diluted with water three times to five hundreds times although the dilution of the acids depends on the chemical resistance of the resist.

In order to remove deposits on the surface of aluminum or aluminum alloy and in order to improve the adhesion of plating due to the anchoring effect, at least one of a degreasing process and a chemical polishing process is preferably carried out with an acidic solution before the zinc immersion process. The degreasing process has the function of preventing defectives due to the deposition of oil contents on the surface of the metal member. The chemical polishing process has the function of activating the surface of the metal member to suppress uneven deposition of zinc in the zinc immersion process (activating process) to subsequently prevent uneven plating and non-plating in the vicinity of the resist.

The electroless nickel alloy plating is preferably carried out in the pH range of 5.5 or less although it is carried out in accordance with the pH stability of the resist. An additional plating process may be carried out after the electroless nickel alloy plating. If a heat treatment is carried out after the plating, it is possible to further improve the adhesion andsolderwettabilityofplating. This heat treatment is preferably carried out in a hydrogen reducing atmosphere.

A metal/ceramic bonding member produced by the above described method according to the present invention may be used as an insulating circuit board for mounting thereon large-power element(s), such as an insulating circuit board for a power module.

Referring now to the accompanying drawings, examples of a metal/ceramic bonding member and a method for producing the same according to the present invention will be described below in detail.

### Example 1

As shown in FIGS. 1 through 4, an aluminum nitride (AlN) substrate having a size of 41 mm x 35.5 mm x 0.635 mm was prepared as a ceramic substrate 10 (see FIG. 1), and pure aluminum plates 12 having a thickness of 0.4 mm were bonded to the AlN substrate 10 by the molten metal bonding method to be polished (see FIG. 2). Thereafter, alkali peeling type resists (MT-UV-5203P produced by Mitsui Chemical Co., Ltd.) 14 were printed on the aluminum plates 12 by the screen printing so as to have a shape of circuit pattern (see FIG. 3), and undesired portions were etched and removed with an iron chloride solution to form a circuit (see FIG. 4).

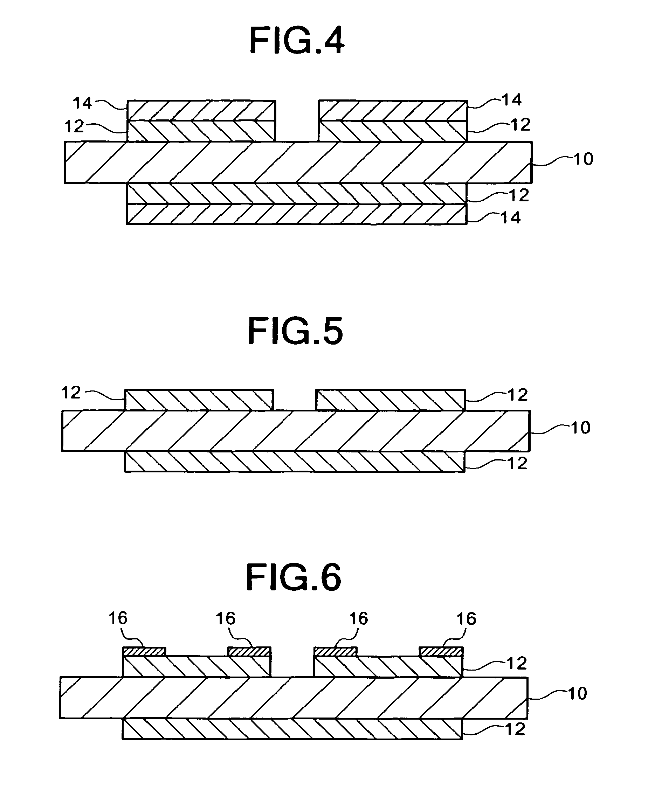

Then, as shown in FIGS. 5 and 6, the resists 14 were removed with a 3% NaOH solution (see FIG. 5), and thereafter, alkali peeling type resists (MT-UV-5203P produced by Mitsui Chemical Co., Ltd.) 16 were printed on the metal circuit portion by the screen printing to be cured so as to have a desired pattern, in order to plate only predetermined portions such as chip mounting portions (see FIG. 6).

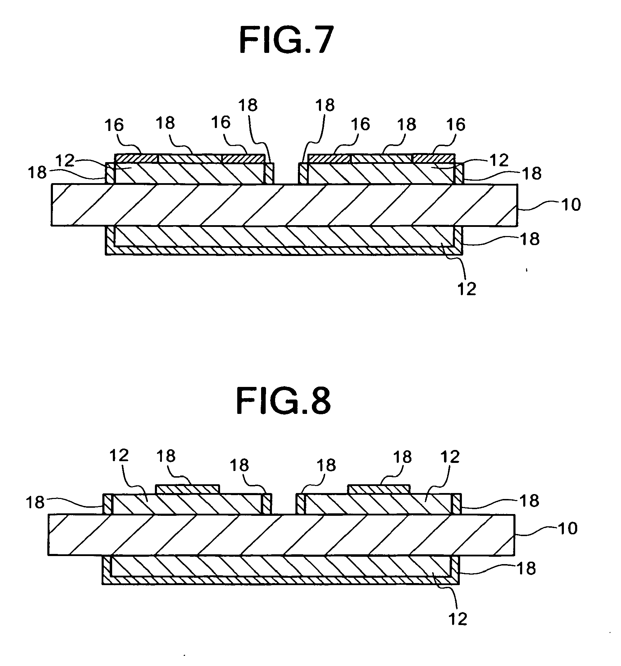

Then, as shown in FIG. 7, the exposed portions of the aluminum plates 12 were treated with a degreasing solution and chemical polishing solution for aluminum, and thereafter, the treated portions of the aluminum plates 12 were activated with an acidic zinc immersion solution containing a fluoride (Albond AM produced by World Metal Co., Ltd.). That is, after zinc was deposited on the treated portions of the aluminum plates 12 using the acidic zinc immersion solution, the treated portions of the aluminum plates 12 were sequentially washed, immersed in 1.4 wt% nitric acid, and washed. Then, zinc was deposited thereon again, and thereafter, the treated portions of the aluminum plates 12 were washed. Thereafter, a nickel-phosphorus alloy plating layer 18 was formed by using an electroless nickel plating solution (Nimuden SX produced by Uemura Kogyo Co., Ltd.) Then, as shown in FIG. 8, the resists 16 were dissolved in and removed with a 3% NaOH solution.

With respect to the metal/ceramic circuit board thus obtained, the adhesion and solder wettability of plating were evaluated. The adhesion of plating was evaluated as good if an adhesive tape, which was applied to each of one hundred or more samples prepared by cutting the plating film one millimeter square by means of a cutter, was not stripped. The solder wettability of plating was evaluated as good if 95% or more of the plated area was wet when the metal/ceramic circuit board was heated on a hot plate at 270 °C for 20 minutes after an Sn-Pb eutectic solder paste (20 mm square, about 0.8 g) was applied on the plated surface. As a result, it was possible to obtain a desired plating pattern having good adhesion and solder wettability of plating. In the visual inspection with the naked eye, uneven plating was not observed, and plating was also deposited in the vicinity of portions from which the applied resists were removed, so that the appearance of the metal/ceramic circuit board was good.

### Example 2

A metal/ceramic circuit board was prepared by the same method as that in Example 1, except that a heat treatment was carried out at 280 °C in a gas atmosphere containing 80% nitrogen and 20% hydrogen after the resists 16 were dissolved in and removed with a 3% NaOH solution. With respect to the metal/ceramic circuit board thus obtained, the evaluation of the adhesion and solder wettability of plating, and the visual inspection were carried out by the same method as that in Example 1. As a result, it was possible to obtain a desired plating pattern having good adhesion and solder wettability of plating, and the appearance of the metal/ceramic circuit board was good.

### Example 3

A metal/ceramic circuit board was prepared by the same method as that in Example 2, except that metal plates of Al-0.5wt% Si were used in place of the pure aluminum plates 12. With respect to the metal/ceramic circuit board thus obtained, the evaluation of the adhesion and solder wettability of plating, and the visual inspection were carried out by the same method as that in Example 1. As a result, it was possible to obtain a desired plating pattern having good adhesion and solder wettability of plating, and the appearance of the metal/ceramic circuit board was good.

### Comparative Example 1

A metal/ceramic circuit board was prepared by the same method as that in Example 1, except that an aqueous solution of an alkali zinc immersion solution (AZ-301-3X produced by Uemura Kogyo Co., Ltd.). With respect to the metal/ceramic circuit board thus obtained, the evaluation of the adhesion and solder wettability of plating, and the visual inspection were carried out by the same method as that in Example 1. As a result, although the adhesion and solder wettability of plating were good, the resists were stripped at the zinc immersion step so as not to obtain a desired plating pattern, and plating was substantially formed on the whole surface.

### Comparative Example 2

A metal/ceramic circuit board was prepared by the same method as that in Example 1, except that organic solvent-soluble resists (M-85K produced by Taiyo Ink Co., Ltd.) were used as the resists 16. With respect to the metal/ceramic circuit board thus obtained, the evaluation of the adhesion and solder wettability of plating, and the visual inspection were carried out by the same method as that in Example 1. As a result, the adhesion and solder wettability of plating were good, so that it was possible to obtain a desired plating pattern. However, the resists remained, so that it was not possible to carry out aluminum wire bonding.

### Comparative Example 3

A metal/ceramic circuit board was prepared by the same method as that in Example 1, except that a chemical containing no fluorides (a chemical prepared by dissolving 1 wt% zinc chloride in an aqueous solution of 0.03 wt% hydrochloric acid) was used as the zinc immersion solution. With respect to the metal/ceramic circuit board thus obtained, the evaluation of the adhesion and solder wettability of plating, and the visual inspection were carried out by the same method as that in Example 1. As a result, the adhesion and solder wettability of plating were good. However, uneven plating was observed, and non-plating was observed in the vicinity of portions from which the applied resists were removed.

## Claims

1. A method for producing a metal/ceramic bonding member, said method comprising the steps of:
bonding a metal member (12) to a ceramic member (10);
applying an alkali peeling type resist (16) having a predetermined shape on a surface of the metal member (12) bonded to said ceramic member (10);
activating a portion of the surface of the metal member (12), on which the resist (16) is not applied, with a zinc immersion solution for depositing zinc thereon; and
carrying out an electroless nickel alloy plating on the activated portion of the surface of the metal member (12), and thereafter, removing the resist (16) with an alkali,
**characterized in that** :
said zinc immersion solution is acidic and contains a fluoride or silicofluoride.

2. A method for producing a metal/ceramic bonding member as set forth in claim 1, wherein said metal member (12) is made of aluminum or an aluminum alloy.

3. A method for producing a metal/ceramic bonding member as set forth in claim 2, wherein said aluminum alloy is selected from the group consisting of aluminum-silicon alloys, aluminum-magnesium alloys, aluminum-silicon-boron alloys and aluminum-magnesium-silicon alloys.

4. A method for producing a metal/ceramic bonding member as set forth in claim 1, wherein said activating step is sequentially carried out twice.

5. A method for producing a metal/ceramic bonding member as set forth in claim 4, wherein an aqueous acidic solution of an acid selected from the group consisting of nitric acid, hydrochloric acid, sulfuric acid and acetic acid is used as a zinc deposition film removing solution at said activating step for removing a zinc deposition film with the zinc deposition film removing solution.

6. A method for producing a metal/ceramic bonding member as set forth in claim 1, wherein said ceramic member (10) mainly contains a component selected from alumina, aluminum nitride, silicon carbide and silicon nitride.

7. A method for producing a metal/ceramic bonding member as set forth in claim 1, wherein said metal member (12) is bonded to said ceramic member (10) by a molten metal bonding method, an impregnation bonding method, a brazing bonding method or a direct bonding method.

8. A method for producing a metal/ceramic bonding member as set forth in claim 1, wherein said electroless nickel alloy plating is selected from the group consisting of a nickel-phosphorus alloy plating, a nickel-boron alloy plating, and a composite plating of a nickel-phosphorus alloy plating and nickel-boron alloy plating.

9. A method for producing a metal/ceramic bonding member as set forth in claim 1, wherein said ceramic member (10) is a ceramic substrate, and said metal member (12) is a metal circuit plate having a predetermined circuit pattern.

10. A method for producing a metal/ceramic bonding member as set forth in claim 1, which further comprises a step of carrying out at least one of a degreasing process or a chemical polishing process before said activating step.

## Patentansprüche

1. Verfahren zum Herstellen eines Metall-/Keramik-Verbundelements, wobei das Verfahren die nachfolgenden Schritte umfasst:
Binden eines Metallelements (12) an ein Keramikelement (10),
Aufbringen einer Schutzschicht (Resistor) vom Alkali-Abzieh-Typ (16) mit einer vorbestimmten Form auf einer Oberfläche des Metallelements (12), welches an das Keramikelement gebunden ist (10),
Aktivieren eines Teils der Oberfläche des Metallelements (10), auf welchem die Schutzschicht (16) nicht aufgebracht ist, mit einer Zinkeintauchlösung zum Abscheiden von Zink darauf und
Durchführen einer stromlosen Nickellegierungsplattierung auf dem aktivierten Teil der Oberfläche des Metallelements (12) und daran anschließend Entfernen der Schutzschicht (16) mit einem Alkali,
**dadurch gekennzeichnet, dass**:
die Zinkeintauchlösung sauer ist und ein Fluorid oder Silicofluorid enthält.

2. Verfahren zum Herstellen eines Metall-/Keramik-Verbundelements nach Anspruch 1, wobei das Metallelement (12) aus Aluminium oder aus einer Aluminiumlegierung hergestellt ist.

3. Verfahren zum Herstellen eines Metall-/Keramik-Verbundelements nach Anspruch 2, wobei die Aluminiumlegierung aus der Gruppe ausgewählt ist, welche aus Aluminium-Silicium-Legierungen, Aluminium-Magnesium-Legierungen, Aluminium-Silicium-Bor-Legierungen und Aluminium-Magnesium-Silicium-Legierungen besteht.

4. Verfahren zum Herstellen eines Metall-/Keramik-Verbundelements nach Anspruch 1, wobei der Aktivierungsschritt zweimal nacheinander durchgeführt wird.

5. Verfahren zum Herstellen eines Metall-/Keramik-Verbundelements nach Anspruch 4, wobei in dem Aktivierungsschritt eine wässrige saure Lösung aus einer Säure ausgewählt aus der Gruppe bestehend aus Salpetersäure, Salzsäure, Schwefelsäure und Essigsäure als eine einen Zinkabscheidefilm entfernende Lösung zum Entfernen eines Zinkabscheidefilms mit der Zinkabscheidefilm entfernenden Lösung eingesetzt wird.

6. Verfahren zum Herstellen eines Metall-/Keramik-Verbundelements nach Anspruch 1, wobei das Keramikelement (10) hauptsächlich eine Komponente enthält, welche aus Aluminiumoxid, Aluminiumnitrid, Siliciumcarbid und Siliciumnitrid ausgewählt wird.

7. Verfahren zum Herstellen eines Metall-/Keramik-Verbundelements nach Anspruch 1, wobei das Metallelement (12) an das Keramikelement (10) durch eine geschmolzene Metallverbindungsmethode, eine Imprägnierungsverbindungsmethode, eine Lötverbindungstechnik oder ein direktes Bindeverfahren gebunden ist.

8. Verfahren zum Herstellen eines Metall-/Keramik-Verbundelements nach Anspruch 1, wobei die stromlose Nickellegierungsplattierung aus der Gruppe ausgewählt ist, welche aus einer Nickel-Phosphor-Legierung-Plattierung, einer Nickel-Bor-Legierung-Plattierung und einer kombinierten Plattierung aus einer Nickel-Phosphor-Legierung-Plattierung und Nickel-Bor-Legierung-Plattierung besteht.

9. Verfahren zum Herstellen eines Metall-/Keramik-Verbundelements nach Anspruch 1, wobei das Keramikelement (10) ein Keramiksubstrat ist und das Metallelement (12) eine Metallschaltungsplatte mit einem vorbestimmten Schaltmuster ist.

10. Verfahren zum Herstellen eines Metall-/Keramik-Verbundelements nach Anspruch 1, welches des Weiteren den Schritt des Durchführens wenigstens eines Entfettungsverfahrens oder eines chemischen Polierverfahrens vor dem Aktivierungsschritt umfasst.

## Revendications

1. Procédé pour produire un élément de liaison métal/matière céramique, ledit procédé comprenant les étapes consistant à :
lier un élément métallique (12) à un élément céramique (10) ;
appliquer un résist de type pelable par un agent alcalin (16) ayant une forme prédéterminée sur une surface de l'élément métallique (12) liée audit élément céramique (10) ;
activer une partie de la surface de l'élément métallique (12), sur laquelle le résist (16) n'est pas appliqué, avec une solution de zinc d'immersion pour déposer du zinc sur celle-ci ; et
effectuer un plaquage autocatalytique d'un alliage de nickel sur la partie activée de la surface de l'élément métallique (12) et, ensuite, éliminer le résist (16) avec un agent alcalin,
**caractérisé en ce que** :
ladite solution de zinc d'immersion est acide et contient un fluorure ou silicofluorure.

2. Procédé pour produire un élément de liaison métal/matière céramique suivant la revendication 1, dans lequel ledit élément métallique (12) est constitué d'aluminium ou d'un alliage d'aluminium.

3. Procédé pour produire un élément de liaison métal/matière céramique suivant la revendication 2, dans lequel ledit alliage d'aluminium est choisi dans le groupe consistant en des alliages aluminium-silicium, des alliages aluminium-magnésium, des alliages aluminium-silicium-bore et des alliages aluminium-magnésium-silicium.

4. Procédé pour produire un élément de liaison métal/matière céramique suivant la revendication 1, dans lequel ladite d'étape d'activation est mise en, oeuvre séquentiellement deux fois.

5. Procédé pour produire un élément de liaison métal/matière céramique suivant la revendication 4, dans lequel une solution acide aqueuse d'un acide choisi dans le groupe consistant en l'acide nitrique, l'acide chlorhydrique, l'acide sulfurique et l'acide acétique est utilisée comme solution d'élimination de film de zinc déposé dans ladite étape d'activation pour l'élimination d'un film de zinc déposé avec la solution d'élimination de film de zinc déposé.

6. Procédé pour produire un élément de liaison métal/matière céramique suivant la revendication 1, dans lequel ledit élément céramique (10) contient principalement un constituant choisi entre l'alumine, le nitrure d'aluminium, le carbure de silicium et le nitrure de silicium.

7. Procédé pour produire un élément de liaison métal/matière céramique suivant la revendication 1, dans lequel ledit élément métallique (12) est lié audit élément céramique (10) par un procédé de liaison de métal fondu, un procédé de liaison par imprégnation, un procédé de liaison par brassage ou un procédé de liaison directe.

8. Procédé pour produire un élément de liaison métal/matière céramique suivant la revendication 1, dans lequel ledit plaquage autocatalytique d'alliage de nickel est choisi dans le groupe consistant en un plaquage d'alliage nickel-phosphore, un plaquage d'alliage nickel-bore, et un plaquage composite constitué d'un plaquage d'alliage nickel-phosphore et d'un plaquage d'alliage nickel-bore.

9. Procédé pour produire un élément de liaison métal/matière céramique suivant la revendication 1, dans lequel ledit élément céramique (10) est un substrat céramique, et ledit élément métallique (12) est une plaque de circuit métallique ayant un motif de circuit prédéterminé.

10. Procédé pour produire un élément de liaison métal/matière céramique suivant la revendication 1, qui comprend en outre une étape de mise en oeuvre d'au moins un d'un procédé de dégraissage et d'un procédé de polissage chimique avant ladite étape d'activation.
